# EUROPÄISCHE PATENTANMELDUNG

(11) **EP 2 854 173 A2**
(43) Veröffentlichungstag der Anmeldung: **01.04.2015**
(21) Anmeldenummer: 14176899.4
(22) Anmeldetag: 14.07.2014
(51) Int. Cl.: H01L 23/473, H01L 23/373, H01L 21/48, H01L 21/58, H01L 23/055

(54) **Leistungshalbleitereinrichtung und Verfahren zur Herstellung einer Leistungshalbleitereinrichtung**

(30) Priorität: 30.09.2013 DE 102013110815
(71) Anmelder: SEMIKRON Elektronik GmbH & Co. KG, 90431 Nürnberg (DE)
(72) Erfinder: Kulas, Hartmut, 90562 Heroldsberg (DE)

(57) **Zusammenfassung**

Die Erfindung betrifft eine Leistungshalbleitereinrichtung mit einem Leistungshalbleitermodul und einem Kühlkörper, wobei das Leistungshalbleitermodul eine Kühlplatte aufweist, wobei der Kühlkörper eine Öffnung aufweist, die von einer die Öffnung umlaufenden lateralen ersten Fläche des Kühlkörpers begrenzt wird, wobei die Kühlplatte in der Öffnung angeordnet ist, wobei eine die Kühlplatte umlaufende laterale erste Fläche der Kühlplatte und die erste Fläche des Kühlkörpers einen jeweiligen Winkel zu einer den Leistungshalbleiterbauelementen zugewandten Hauptfläche der Kühlplatte von kleiner als 90° aufweisen, wobei die erste Fläche der Kühlplatte und die erste Fläche des Kühlkörpers, umlaufend entlang der ersten Fläche der Kühlplatte und umlaufend entlang der ersten Fläche des Kühlkörpers, aneinander gepresst angeordnet sind. Weiterhin betrifft die Erfindung ein Verfahren zur Herstellung einer diesbezüglichen Leistungshalbleitereinrichtung. Die Erfindung schafft eine Leistungshalbleitereinrichtung, die eine gute Wärmeleitung von den Leistungshalbleiterbauelementen zu einem von einem Flüssigkeit durchströmbaren Kühlkörper der Leistungshalbleitereinrichtung aufweist und bei der der Kühlkörper langfristig und zuverlässig dicht ist.

## Beschreibung

Die Erfindung betrifft eine Leistungshalbleitereinrichtung. Weiterhin betrifft die Erfindung ein Verfahren zur Herstellung einer Leistungshalbleitereinrichtung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Im Betrieb der Leistungshalbleitereinrichtung treten an den Leistungshalbleiterbauelementen elektrische Verluste auf, die zu einer Erwärmung der Leistungshalbleiterbauelemente führen. Zur Kühlung der Leistungshalbleiterbauelemente weisen technikübliche Leistungshalbleitereinrichtungen oftmals einen von einer Kühlflüssigkeit durchströmten Kühlkörper auf, der thermisch leitend an die Leistungshalbleiterbauelemente angekoppelt ist.

Aus der DE 10 2010 043 446 B3 ist es bekannt, einen von einer Kühlflüssigkeit durchströmten Kühlkörper mit Öffnungen zu versehen und in die Öffnungen die Kühlplatte von Leistungshalbleitermodulen, die Leistungshalbleiterbauelemente aufweisen, anzuordnen. Hierdurch wird eine gute Wärmeabfuhr von den Leistungshalbleiterbauelementen zur Kühlflüssigkeit erzielt. Nachteilig hierbei ist, dass die Kühlplatte langfristig und zuverlässig gegen den Kühlkörper abgedichtet sein muss um einen Austritt von Kühlflüssigkeit zuverlässig über die in der Regel lange vorgesehene Nutzungsdauer der Leistungshalbleitereinrichtung zu verhindern.

Es ist Aufgabe der Erfindung eine Leistungshalbleitereinrichtung zu schaffen, die eine gute Wärmeleitung von den Leistungshalbleiterbauelementen zu einem von einem Flüssigkeit durchströmbaren Kühlkörper der Leistungshalbleitereinrichtung aufweist und bei der der Kühlkörper langfristig und zuverlässig dicht ist.

Diese Aufgabe wird gelöst durch eine Leistungshalbleitereinrichtung mit einem Leistungshalbleitermodul und einem von einer Flüssigkeit durchströmbaren Kühlkörper, wobei das Leistungshalbleitermodul Leistungshalbleiterbauelemente, die auf elektrisch leitenden Leiterbahnen angeordnet sind, aufweist, wobei das Leistungshalbleitermodul eine elektrisch nicht leitende Isolationsschicht und eine Kühlplatte aufweist, wobei die Isolationsschicht zwischen den Leiterbahnen und der Kühlplatte angeordnet ist, wobei der Kühlkörper eine Öffnung aufweist, die von einer die Öffnung umlaufenden lateralen ersten Fläche des Kühlkörpers begrenzt wird, wobei die Kühlplatte in der Öffnung angeordnet ist, wobei eine die Kühlplatte umlaufende laterale erste Fläche der Kühlplatte einen Winkel zu einer den Leistungshalbleiterbauelementen zugewandten Hauptfläche der Kühlplatte von kleiner als 90° aufweist und die erste Fläche des Kühlkörpers zu der den Leistungshalbleiterbauelementen zugewandten Hauptfläche der Kühlplatte einen Winkel von kleiner als 90° aufweist, wobei die erste Fläche der Kühlplatte und die erste Fläche des Kühlkörpers, umlaufend entlang der ersten Fläche der Kühlplatte und umlaufend entlang der ersten Fläche des Kühlkörpers, aneinander gepresst angeordnet sind.

Weiterhin wird diese Aufgabe gelöst durch ein Verfahren zur Herstellung einer Leistungshalbleitereinrichtung mit folgenden Verfahrensschritten:
a) Bereitstellen eines Leistungshalbleitermoduls, das Leistungshalbleiterbauelemente, die auf elektrische leitenden Leiterbahnen angeordnet sind, aufweist, wobei das Leistungshalbleitermodul eine elektrisch nicht leitende Isolationsschicht und eine Kühlplatte aufweist, wobei die Isolationsschicht zwischen den Leiterbahnen und der Kühlplatte angeordnet ist, wobei eine die Kühlplatte umlaufende laterale erste Fläche der Kühlplatte einen Winkel zu einer den Leistungshalbleiterbauelementen zugewandten Hauptfläche der Kühlplatte von kleiner als 90° aufweist, und Bereitstellen eines von einer Flüssigkeit durchströmbaren Kühlkörpers, der eine Öffnung aufweist, die von einer die Öffnung umlaufenden lateralen ersten Fläche des Kühlkörpers begrenzt wird,
b) Anordnen der Kühlplatte an der Öffnung des Kühlkörpers,
c) Einpressen der Kühlplatte in die Öffnung des Kühlkörpers, wobei nach dem Einpressen die erste Fläche der Kühlplatte und die erste Fläche des Kühlkörpers umlaufend entlang der ersten Fläche der Kühlplatte und umlaufend entlang der ersten Fläche des Kühlkörpers aneinander gepresst angeordnet sind, wobei die erste Fläche des Kühlkörpers zu der den Leistungshalbleiterbauelementen zugewandten Hauptfläche der Kühlplatte einen Winkel von kleiner als 90° aufweist.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen der Leistungshalbleitereinrichtung und umgekehrt.

Es erweist sich als vorteilhaft, wenn die die Kühlplatte umlaufende laterale erste Fläche der Kühlplatte einen Winkel zu der den Leistungshalbleiterbauelementen zugewandten Hauptfläche der Kühlplatte von 89,5° bis 85° aufweist, da sich bei diesem Winkelbereich eine besonders gute Aneinanderpressung der ersten Fläche der Kühlplatte und der ersten Fläche des Kühlkörpers ergibt.

Weiterhin erweist es sich als vorteilhaft, wenn die erste Fläche des Kühlkörpers zu der den Leistungshalbleiterbauelementen zugewandten Hauptfläche der Kühlplatte einen Winkel aufweist, der gleich dem Winkel der ersten Fläche der Kühlplatte zu der den Leistungshalbleiterbauelementen zugewandten Hauptfläche der Kühlplatte ist, da dann die erste Fläche des Kühlkörpers und die erste Fläche der Kühlplatte über einen großen umlaufende Flächenbereich aneinander gepresst angeordnet sind.

Weiterhin erweist es sich als vorteilhaft, wenn der Kühlkörper eine Öffnung aufweist, die von der die Öffnung umlaufenden lateralen ersten Fläche und von einer die Öffnung umlaufenden lateralen zweiten Fläche des Kühlkörpers begrenzt wird, wobei die zweite Fläche des Kühlkörpers, die Innenfläche einer um die Öffnung umlaufenden ersten Nut bildet, wobei ein Randbereich der Kühlplatte eine um die Kühlplatte umlaufende Auswölbung aufweist, die in der ersten Nut angeordnet ist. Hierdurch wird eine besonders zuverlässige langfristige Abdichtung der Kühlplatte gegen den Kühlkörper erzielt.

Weiterhin erweist es sich als vorteilhaft, wenn die Öffnung von der die Öffnung umlaufenden lateralen ersten Fläche des Kühlkörpers und von einer die Öffnung umlaufenden lateralen zweiten Fläche des Kühlkörpers begrenzt wird, wobei die zweite Fläche des Kühlkörpers, die Innenfläche einer um die Öffnung umlaufenden ersten Nut bildet, mit folgendem weiteren Verfahrensschritt:
d) Verformen eines lateralen Randbereichs der Kühlplatte derart, dass der Randbereich eine um die Kühlplatte umlaufende Auswölbung aufweist, die nach dem Verformen des lateralen Randbereichs der Kühlplatte in der ersten Nut angeordnet ist. Die Auswölbung bewirkt eine zusätzliche flüssigkeitsdichte Abdichtung der Kühlplatte gegen den Kühlkörper und blockiert durch die formschlüssige Verbindung der Auswölbung mit der ersten Nut eine Bewegung der Kühlplatte aus der Öffnung heraus.

Ferner erweist es sich als vorteilhaft, wenn beim Einpressen der Kühlplatte in die Öffnung des Kühlkörpers ein Einschneiden einer von der ersten Fläche der Kühlplatte beanstandeten umlaufenden zweiten Nut in die den Leistungshalbleiterbauelementen zugewandte Hauptfläche der Kühlplatte durchgeführt wird. Hierdurch wird eine rationelle Herstellung der Leistungshalbleitereinrichtung erzielt, wobei die zweite Nut das Verformen des lateralen Randbereichs der Kühlplatte erleichtert.

Weiterhin erweist es sich als vorteilhaft, wenn beim Verfahrensschritt a) die den Leistungshalbleiterbauelementen zugewandte Hauptfläche der Kühlplatte eine von der ersten Fläche der Kühlplatte beanstandete umlaufende zweite Nut aufweist. Die zweite Nut erleichtert das Verformen des lateralen Randbereichs der Kühlplatte.

Weiterhin erweist es sich als vorteilhaft, wenn das Verfahren mittels eines einen Einpressstempels und einen Verformstempel aufweisenden Werkzeugs durchführt wird, wobei das Einpressen der Kühlplatte in die Öffnung des Kühlkörpers mittels des Einpressstempels durchgeführt wird und das Verformen des lateralen Randbereichs der Kühlplatte mittels des Verformstempels durchgeführt wird, wobei der Verformstempel lateral um den Einpressstempel herum und gegenüber dem Einpressstempel beweglich angeordnet ist.

Ausführungsbeispiele der Erfindung sind den Figuren dargestellt und werden im Folgenden näher erläutert. Dabei zeigen:
- FIG 1: ein erster Verfahrensschritt zur Herstellung einer erfindungsgemäßen Leistungshalbleitereinrichtung,
- FIG 2: eine Schnittansicht eines Leistungshalbleitermoduls,
- FIG 3: ein weiterer Verfahrensschritt zur Herstellung einer erfindungsgemäßen Leistungshalbleitereinrichtung,
- FIG 4: ein Detailansicht eines weiteren Verfahrensschritts zur Herstellung einer erfindungsgemäßen Leistungshalbleitereinrichtung,
- FIG 5: ein Detailansicht eines weiteren Verfahrensschritts zur Herstellung einer erfindungsgemäßen Leistungshalbleitereinrichtung,
- FIG 6: eine Schnittansicht einer erfindungsgemäßen Leistungshalbleitereinrichtung,
- FIG 7: eine Detailansicht von FIG 6,
- FIG 8: eine Schnittansicht einer weiteren erfindungsgemäßen Leistungshalbleitereinrichtung,
- FIG 9: eine Schnittansicht einer weiteren erfindungsgemäßen Leistungshalbleitereinrichtung und
- FIG 10: eine Schnittansicht einer weiteren erfindungsgemäßen Leistungshalbleitereinrichtung.

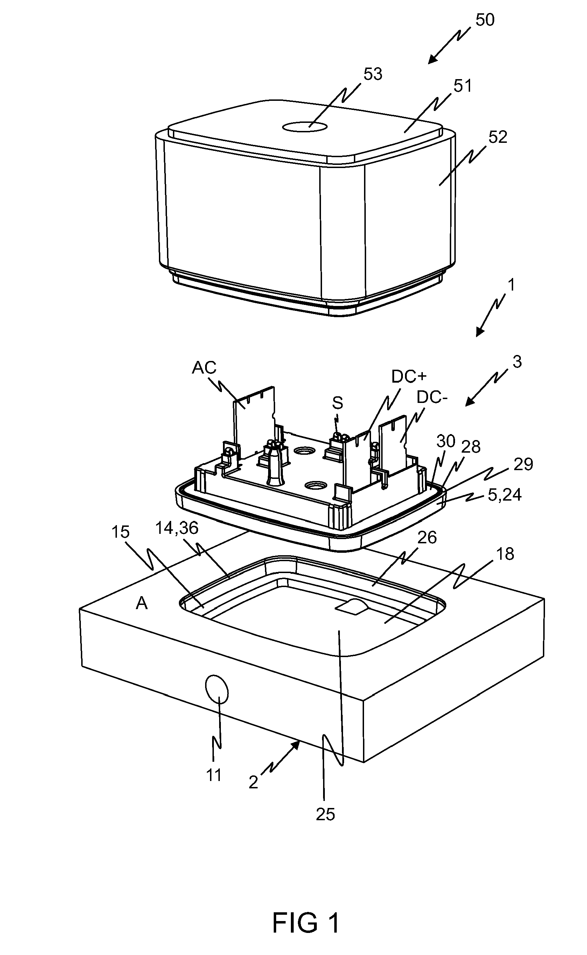

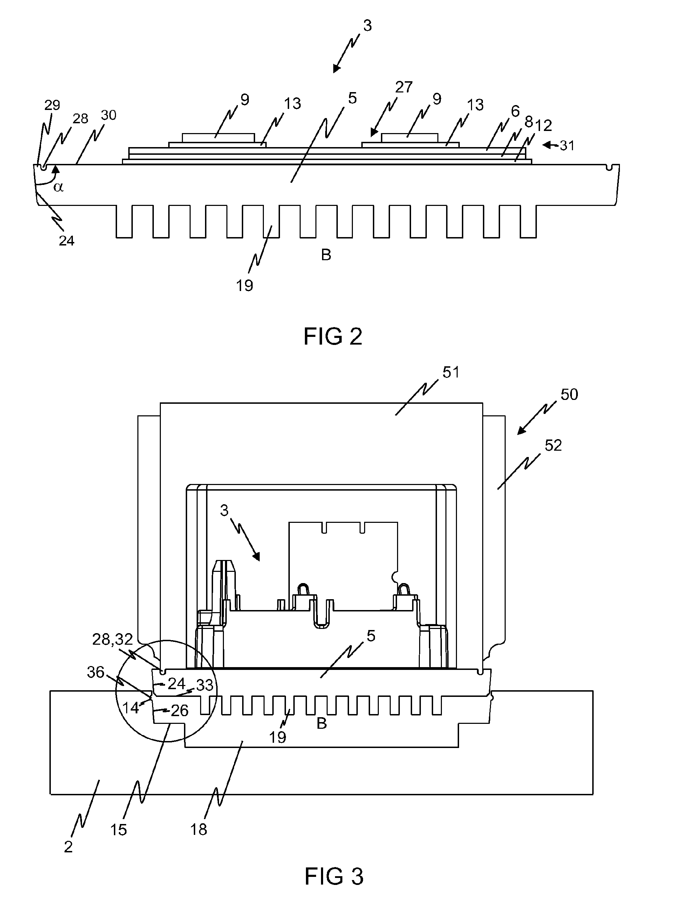

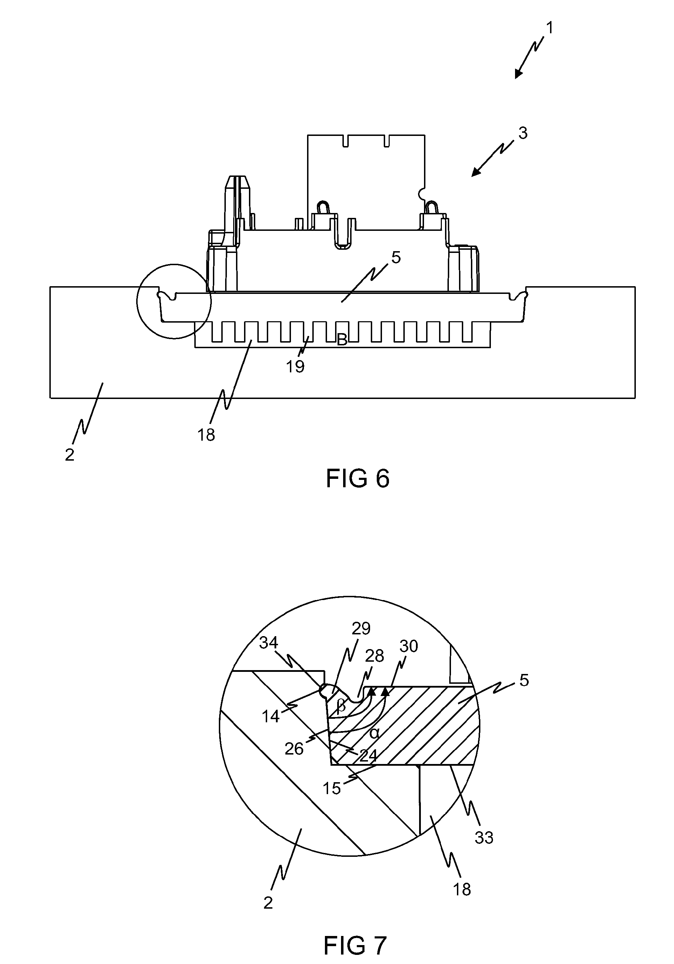

In FIG 1 ist ein erster Verfahrensschritt zur Herstellung einer erfindungsgemäßen Leistungshalbleitereinrichtung 1 (siehe FIG 6) dargestellt. In FIG 2 ist eine Schnittansicht eines Leistungshalbleitermoduls 3 dargestellt, wobei in FIG 2 nur die zum Verständnis der Erfindung wesentlichen Elemente des Leistungshalbleitermoduls 3 dargestellt sind. Es sei angemerkt, dass in FIG 2, FIG 3, FIG 6 und FIG 8 bis FIG 10 der Übersichtlichkeit halber die geschnittenen Elemente nicht schraffiert dargestellt sind.

In dem ersten Verfahrensschritt zur Herstellung der erfindungsgemäßen Leistungshalbleitereinrichtung 1 erfolgt ein Bereitstellen eines Leistungshalbleitermoduls 3, das Leistungshalbleiterbauelemente 9, die auf elektrische leitenden Leiterbahnen 13 angeordnet sind, aufweist, wobei das Leistungshalbleitermodul 3 eine elektrisch nicht leitende Isolationsschicht 6 und eine Kühlplatte 5 aufweist. Die Isolationsschicht 6 ist zwischen den Leiterbahnen 9 und der Kühlplatte 5 angeordnet. Eine die Kühlplatte 5 umlaufende laterale erste Fläche 24 der Kühlplatte 5 weist einen Winkel α zu einer den Leistungshalbleiterbauelementen 9 zugewandten Hauptfläche 14 der Kühlplatte von kleiner als 90° auf. Vorzugsweise weist die die Kühlplatte umlaufende laterale erste Fläche 24 der Kühlplatte 5 einen Winkel α zu der den Leistungshalbleiterbauelementen 9 zugewandten Hauptfläche 30 der Kühlplatte 5 von 89,5° bis 85° auf. Weiterhin erfolgt in dem ersten Verfahrensschritt ein Bereitstellen eines von einer Flüssigkeit durchströmbaren Kühlkörpers 2, der eine Öffnung 25 aufweist, die von einer die Öffnung 25 umlaufenden lateralen ersten Fläche 26 des Kühlkörpers 2 begrenzt wird.

Das Leistungshalbleitermodul 3 weist Leistungshalbleiterbauelemente 9, die auf elektrisch leitenden Leiterbahnen 13 angeordnet sind, auf. Die Leiterbahnen 13 werden durch eine elektrisch leitende strukturierte erste Leitungsschicht 31 ausgebildet. Die Leistungshalbleiterbauelemente 9 sind mit den Leiterbahnen 13, vorzugsweise über eine Löt- oder Sintermetallschicht, elektrisch leitend verbunden. Das jeweilige Leistungshalbleiterbauelement liegt vorzugweise in Form eines Leistungshalbleiterschalters oder einer Diode vor. Die Leistungshalbleiterschalter liegen dabei vorzusgweise in Form von Transistoren, wie z.B. IGBTs (Insulated Gate Bipolar Transistor) oder MOSFETs (Metal Oxide Semiconductor Field Effect Transistor) vor. Das jeweilige Leistungshalbleitermodul 3 weist vorzugsweise ein erstes Gleichspannungslaststromanschlusselement DC+ und einen zweites Gleichspannungslaststromanschlusselement DC- und ein Wechselstromlastanschlusselement AC auf, die mit der ersten Leitungsschicht 31 vorzugsweise über eine Löt- oder Sintermetallschicht, elektrisch leitend verbunden sind. Im Rahmen des Ausführungsbeispiels erzeugt das jeweilige Leistungshalbleitermodul 3 aus einer zwischen den Gleichspannungslaststromanschlüssen DC+ und DC- eingespeisten Gleichspannung am Wechselspannungslaststromanschluss AC eine Wechselspannung. Weiterhin weist das jeweilige Leistungshalbleitermodul 3 im Rahmen des Ausführungsbeispiels Steueranschlusselemente S auf, die elektrisch leitend mit den Steueranschlüssen der Leistungshalbleiterschalter des Leistungshalbleitermoduls 3 verbunden sind.

Weiterhin weist das jeweilige Leistungshalbleitermodul 3 eine elektrisch nicht leitende Isolationsschicht 6 und eine Kühlplatte 5 auf, wobei die Isolationsschicht 6 zwischen den Leiterbahnen 13 und der Kühlplatte 5 angeordnet ist. Die Leiterbahnen 13 sind mit der Isolationsschicht 6 verbunden. Im Rahmen des Ausführungsbeispiels ist zwischen der Isolationsschicht 6 und der Kühlplatte 5 eine elektrisch leitende vorzugweise unstrukturierte zweite Leitungsschicht 8 angeordnet, die mit der Isolationsschicht 6 verbunden ist. Die Isolationsschicht 6 liegt vorzugsweise in Form eines Keramikkörpers vor. Die erste und zweite Leitungsschicht 31 und 8 und die Isolationsschicht 6 werden zusammen vorzugsweise durch ein Direct Copper Bonded Substrat (DCB-Substrat) ausgebildet.

Es sei an dieser Stelle angemerkt, dass die erste und die zweite Leitungsschicht aus einer einzelnen Schicht oder auch mehreren übereinanderliegenden Schichten bestehen können. So kann die erste und/oder die zweite Leitungsschicht z.B. eine Kupferschicht aufweisen, die eine einzelne oder mehrere übereinanderliegende Beschichtungen, z.B. aus einem Edelmetall (z.B. Silber) oder aus einer Edelmetallverbindung aufweist, welche z.B. als Haftvermittlungsschichten und/oder Schutzschichten dienen können.

Die Kühlplatte 5 kann an Ihrer den Leistungshalbleiterbauelementen 9 zugewandten Seite mit einer einzelnen oder mehreren übereinanderliegende Schichten beschichtet sein, die z.B. jeweilig als Haftvermittlungsschicht und/oder als Schutzschicht dienen können und/oder dazu dienen können mechanische Spannungen zwischen Isolationsschicht 6 und der Kühlplatte 5, welche bei Temperaturänderungen, aufgrund unterschiedlicher Temperaturausdehnungskoeffizienten von Isolationsschicht 6 und Kühlplatte 5, auftreten können, zu reduzieren. Im Rahmen des Ausführungsbeispiels ist die Kühlplatte 5 an Ihrer der Isolationsschicht 6 zugewandten Seite mit einer Kupferschicht 12 beschichtet, die wiederum z.B. mit einer Beschichtung, insbesondere einer Edelmetallbeschichtung (z.B. Silber) beschichtet sein kann. Die Kupferschicht 12 ist zwischen Kühlplatte 5 und Isolationsschicht 6, und insbesondere zwischen Kühlplatte und zweiter Leitungsschicht 8 angeordnet. Die zweite Leitungsschicht 8 ist mit der Kühlplatte 5, vorzugsweise über eine Löt- oder Sintermetallschicht, direkt oder indirekt (falls die Kühlplatte an Ihrer den Leistungshalbleiterbauelementen zugewandten Seite mit einer einzelnen oder mehreren übereinanderliegenden Schichten beschichtet ist) verbunden. Die zweite Leitungsschicht 8 ist im Rahmen des Ausführungsbeispiels über eine Löt- oder Sintermetallschicht mit der Kupferschicht 12 verbunden.

Der Übersichtlichkeit halber sind in FIG 2 die Löt- oder Sintermetallschichten nicht dargestellt. Weiterhin sei angemerkt, dass die Dicke der Schichten und die Dicke der Leistungshalbleiterbauelemente nicht maßstabsgerecht dargestellt sind.

Es sei an dieser Stelle angemerkt, dass die Kühlplatte auch in Form eines Aluminiumkörpers eines Insulated Metal Substrats (IMS) vorliegen kann.

Die Kühlplatte 5 weist vorzugsweise an ihrer den Leitungshalbleiterbauelementen 9 abgewandten Seite B Kühlfinnen und/oder Kühlpins 19 auf.

Der von einer Flüssigkeit (z.B. Wasser) durchströmbare Kühlkörper 2 weist an einer den Leistungshalbleiterbauelementen 9 zugewandten Außenseite A des Kühlkörpers 2 eine Öffnung 25 auf. Die Kühlplatte 5 des Leistungshalbleitermoduls 3 ist dabei bei der fertig hergestellten Leistungshalbleitereinrichtung 1 (siehe FIG 6) in der Öffnung 25 angeordnet, wobei ein Teil der jeweiligen Kühlplatte 5 aus der Öffnung 25 herausragen kann. Die Kühlplatte 5 verschließt die Öffnung 25. An einer den Leistungshalbleiterbauelementen 9 abgewandten Seite B der Kühlplatte 2 ist ein Hohlraum 18 ausgebildet. Die Flüssigkeit durchströmt im Rahmen des Ausführungsbeispiels den Kühlkörper 2, indem sie, solange die Öffnung 25 noch nicht durch die Kühlplatte 5 verschlossen ist, durch eine Eingangsöffnung (in der Perspektive von FIG 1 ist die Eingangsöffnung nicht zu sehen) des Kühlkörper 2 in den Hohlraum 18 einströmt, den Hohlraum 18 durchströmt und durch eine Ausgangsöffnung 11 und durch die Öffnung 25 des Kühlkörper 2 aus dem Kühlkörper 2 ausströmt. Die Flüssigkeit durchströmt im Rahmen des Ausführungsbeispiels den Kühlkörper 2, indem sie wenn die Öffnung 25 durch die Kühlplatte 5 verschlossen ist, durch die Eingangsöffnung des Kühlkörper 2 in den Hohlraum 18 einströmt, den Hohlraum 18 durchströmt und durch die Ausgangsöffnung 11 des Kühlkörper 2 aus dem Kühlkörper 2 ausströmt. Die Wärme der jeweiligen Kühlplatte 5 wird auf die Flüssigkeit übertragen und von der Flüssigkeit abtransportiert.

Die Kühlplatte 5 und/oder der Kühlkörpers 2 bestehen vorzugsweise jeweilig aus Aluminium oder einer Aluminiumlegierung.

In einem weiteren Verfahrensschritt erfolgt, wie in FIG 3 dargestellt, ein Anordnen der Kühlplatte 5 an der Öffnung 25 des Kühlkörpers 2. Im Rahmen des Ausführungsbeispiels wird das Anordnen der Kühlplatte 5 an der Öffnung 25 des Kühlkörpers 2 mittels eines einen Einpressstempel 51 und einen Verformstempel 52 aufweisenden Werkzeugs 50 durchgeführt. Der Verformstempel 52 ist lateral um den Einpressstempel 51 herum und gegenüber dem Einpressstempel 51 beweglich angeordnet. Über eine Öffnung 53 des Einpressstempel 51 (siehe FIG 1) wird ein Unterdruck erzeugt, der die Kühlplatte 5 an den Einpressstempel 51 ansaugt und am Einpressstempel 51 hält.

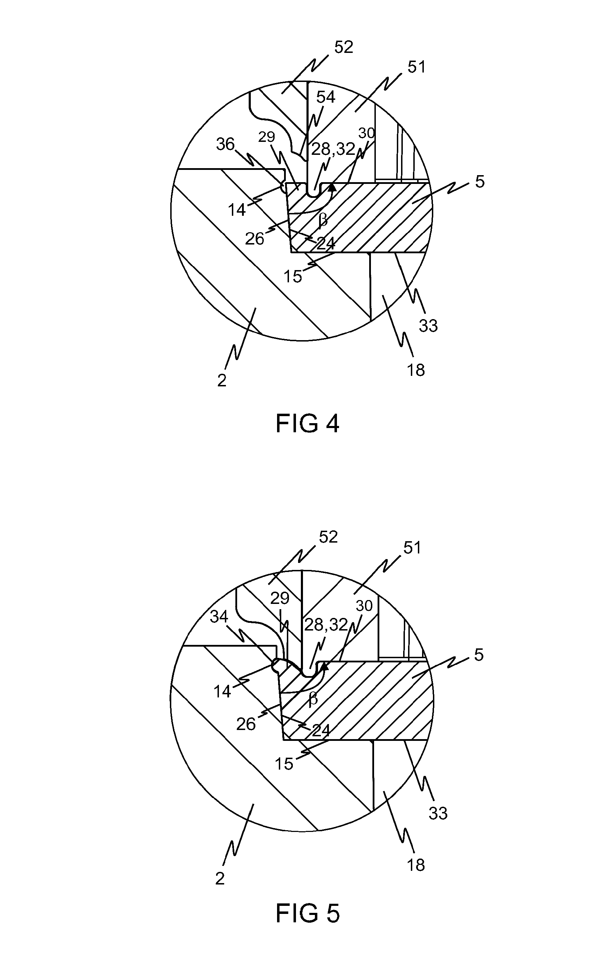

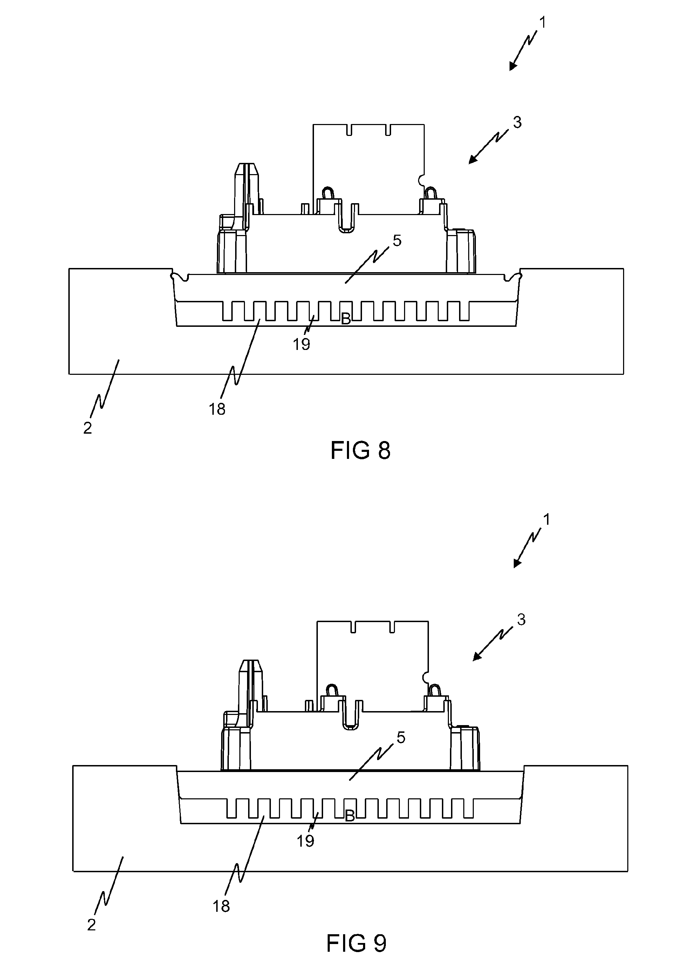

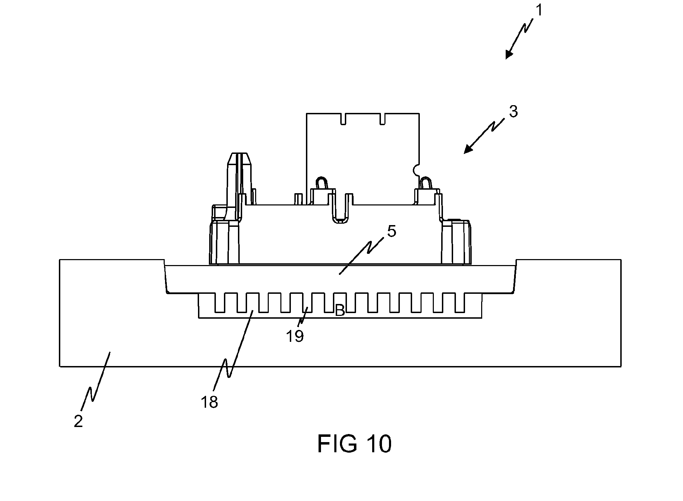

In einem weiteren Verfahrensschritt erfolgt, wie in FIG 4 dargestellt, ein Einpressen der Kühlplatte 5 in die Öffnung 25 des Kühlkörpers 2, wobei nach dem Einpressen die erste Fläche 24 der Kühlplatte 5 und die erste Fläche 26 des Kühlkörpers 2 umlaufend entlang der ersten Fläche 24 der Kühlplatte 5 und der ersten Fläche 26 des Kühlkörpers 2 aneinander gepresst angeordnet sind, wobei die erste Fläche 26 des Kühlkörpers 2 zu der den Leistungshalbleiterbauelementen 9 zugewandten Hauptfläche 30 der Kühlplatte 5 einen Winkel β von kleiner als 90° aufweist. Vorzugsweise weist die erste Fläche 26 des Kühlkörpers 2 zu der den Leistungshalbleiterbauelementen 9 zugewandten Hauptfläche 24 der Kühlplatte 5 einen Winkel β auf, der gleich dem Winkel α der ersten Fläche 24 der Kühlplatte 5 zu der den Leistungshalbleiterbauelementen 9 zugewandten Hauptfläche 30 der Kühlplatte 5 ist. Beim Einpressen der Kühlplatte 5 in die Öffnung 25 des Kühlkörpers 2 wird die Kühlplatte 5 in die Öffnung 25 so tief gedrückt bis die erste Fläche 24 der Kühlplatte 5 und die erste Fläche 26 des Kühlkörpers 2, umlaufend entlang der ersten Fläche 24 der Kühlplatte 5 und umlaufend entlang der ersten Fläche 26 des Kühlkörpers 2, aneinander gepresst angeordnet sind (siehe auch FIG 8 und FIG 9). Die erste Fläche 24 der Kühlplatte 5 und die erste Fläche 26 des Kühlkörpers 2 weisen umlaufend entlang der ersten Fläche 24 der Kühlplatte 5 und umlaufend entlang der ersten Fläche 26 des Kühlkörpers 2 einen Kontakt zueinander auf. Die Kühlplatte 5 ist in die Öffnung 25 eingepresst angeordnet. Vorzugsweise weist der Kühlkörper 2 eine dritte Fläche 15 auf, die parallel zu einer den Leistungshalbleiterbauelementen 9 abgewandten zweiten Fläche 33 der Kühlplatte 5 verläuft. Die dritte Fläche 15 des Kühlkörpers 2 bildet einen Anschlag für die zweite Fläche 33 der Kühlplatte 5 und begrenzt die Einpresstiefe mit der die Kühlplatte 5 in die Öffnung 25 gedrückt werden kann. Vorzugsweise wird die Kühlplatte 5 in die Öffnung 25 so tief gedrückt bis die zweite Fläche 33 der Kühlplatte 5 an der dritten Fläche 15 des Kühlkörpers 2 anliegt. Durch entsprechende Wahl wie tief die dritte Fläche 15 des Kühlkörpers 2 im Kühlkörper 2 angeordnet ist, kann der Anpressdruck mit der die erste Fläche 24 der Kühlplatte 5 und die erste Fläche 26 des Kühlkörpers 2, umlaufend entlang der ersten Fläche 24 der Kühlplatte 5 und umlaufend entlang der ersten Fläche 26 des Kühlkörpers 2, aneinander gepresst angeordnet sind, festgelegt werden. Das Einpressen der Kühlplatte 5 in die Öffnung 25 des Kühlkörpers 2 erfolgt beim Ausführungsbeispiel mittels des Einpressstempels 51. Dadurch, dass die erste Fläche 24 der Kühlplatte 5 und die erste Fläche 26 des Kühlkörpers 2, umlaufend entlang der ersten Fläche 24 der Kühlplatte 5 und umlaufend entlang der ersten Fläche 26 des Kühlkörpers 2, aneinander gepresst angeordnet sind, wird eine zuverlässige langfristige flüssigkeitsdichte Abdichtung der ersten Fläche 26 des Kühlkörpers 2 gegen die erste Fläche 24 der Kühlplatte 5 erzielt (siehe auch FIG 10). Der Kühlkörper 2 ist solchermaßen langfristig und zuverlässig dicht.

Im Rahmen des Ausführungsbeispiels wird die Öffnung 25 von der die Öffnung 25 umlaufenden lateralen ersten Fläche 26 des Kühlkörpers 2 und von einer die Öffnung 25 umlaufenden lateralen zweiten Fläche 14 des Kühlkörpers 2 begrenzt, wobei die zweite Fläche 14 des Kühlkörpers 2, die Innenfläche einer um die Öffnung 25 umlaufenden ersten Nut 36 bildet.

Im Rahmen des Ausführungsbeispiels erfolgt in einem weiteren Verfahrensschritt, wie in FIG 5 dargestellt, ein Verformen eines lateralen Randbereichs 29 der Kühlplatte 5 derart, dass der Randbereich 29 einen um die Kühlplatte 5 umlaufende Auswölbung 34 aufweist, die nach dem Verformen des lateralen Randbereichs 29 der Kühlplatte 5 in der ersten Nut 36 angeordnet ist. Die Auswölbung 34 bewirkt eine zusätzliche flüssigkeitsdichte Abdichtung der Kühlplatte 5 gegen den Kühlkörper 2 und blockiert durch die formschlüssige Verbindung der Auswölbung 34 mit der ersten Nut 36 eine Bewegung der Kühlplatte 5 aus der Öffnung 25 heraus. Beim Ausführungsbeispiel erfolgt das Verformen des lateralen Randbereichs 29 der Kühlplatte 2 mittels des Verformstempels 52. Der Verformstempel 52 weist eine Verformkante 54 auf (siehe FIG 4), die bei einer Bewegung des Verformstempels 52 auf den Randbereichs 29 der Kühlplatte 5, den Randbereich 29 der Kühlplatte 5 entsprechend verformt.

Im Rahmen des Ausführungsbeispiels weist die den Leistungshalbleiterbauelementen 9 zugewandte Hauptfläche 30 (siehe FIG 1 und FIG 2), der im ersten Verfahrensschritt bereitgestellten Kühlplatte 5, eine von der ersten Fläche 24 der Kühlplatte 5 beanstandete umlaufende zweite Nut 28 auf. Die zweite Nut 28 erleichtert das Verformen des lateralen Randbereichs 29 der Kühlplatte 5. Vorzugsweise weist der Einpressstempels 51 eine umlaufende Kante 32 auf, die in die zweite Nut 28 eingreift (siehe FIG 3). Hierdurch wird ein sehr präzises Anordnen der Kühlplatte an der Öffnung des Kühlkörpers ermöglicht.

Die zweite Nut 28 braucht nicht schon zu Beginn des Verfahrens vorhanden zu sein. Alternativ kann beim Einpressen der Kühlplatte 5 in die Öffnung 25 des Kühlkörpers 2 auch ein Einschneiden einer von der ersten Fläche 24 der Kühlplatte 5 beanstandeten umlaufenden zweiten Nut 28 in die den Leistungshalbleiterbauelementen 9 zugewandte Hauptfläche 30 der Kühlplatte 5 durchgeführt werden. Die umlaufende Kante 32 des Einpressstempels 51 liegt in diesem Fall Form einer Schneidkannte vor. Hierdurch wird eine rationelle Herstellung der Leistungshalbleitereinrichtung erzielt.

In FIG 8 ist eine Schnittansicht einer weiteren erfindungsgemäßen Leistungshalbleitereinrichtung 1 dargestellt, die mit der Leistungshalbleitereinrichtung 1 gemäß FIG 6 und FIG 7 bis auf das Merkmal, dass der Kühlkörper 2 der erfindungsgemäßen Leistungshalbleitereinrichtung 1 gemäß FIG 8 keine dritte Fläche 15 aufweist, die einen Anschlag für die zweite Fläche 33 der Kühlplatte 5 bildet, übereinstimmt.

In FIG 9 ist eine Schnittansicht einer weiteren erfindungsgemäßen Leistungshalbleitereinrichtung 1 dargestellt, die mit der Leistungshalbleitereinrichtung 1 gemäß FIG 8 bis auf die Merkmale, dass der Kühlkörpers 2 keine erste Nut 36 aufweist und kein Verformen des lateralen Randbereichs 29 der Kühlplatte 5 erfolgt ist, übereinstimmt. Die Kühlplatte der Leistungshalbleitereinrichtung 1 gemäß FIG 9 kann, was in FIG 9 nicht dargestellt ist, auch die zweite Nut 28 aufweisen, die in Verbindung mit der umlaufenden Kante 32 des Einpressstempels 51, die in die zweite Nut 28 eingreift, ein sehr präzises Anordnen der Kühlplatte an der Öffnung des Kühlkörpers ermöglicht.

In FIG 10 ist eine Schnittansicht einer weiteren erfindungsgemäßen Leistungshalbleitereinrichtung 1 dargestellt, die mit der Leistungshalbleitereinrichtung 1 gemäß FIG 6 und FIG 7 bis auf die Merkmale, dass der Kühlkörper 2 keine erste Nut 36 aufweist und kein Verformen des lateralen Randbereichs 29 der Kühlplatte 5 erfolgt ist, übereinstimmt. Die Kühlplatte der Leistungshalbleitereinrichtung 1 gemäß FIG 10 kann, was in FIG 10 nicht dargestellt ist, auch die zweite Nut 28 aufweisen, die in Verbindung mit der umlaufenden Kante 32 des Einpressstempels 51, die in die zweite Nut 28 eingreift, ein sehr präzises Anordnen der Kühlplatte an der Öffnung des Kühlkörpers ermöglicht.

Es sei allgemein angemerkt, dass die erfindungsgemäße Leistungshalbleitereinrichtung 1 auch mehrere Leistungshalbleitermodule 3 aufweisen kann, wobei falls die erfindungsgemäße Leistungshalbleitereinrichtung 1 mehrere Leistungshalbleitermodule 3 aufweist, der Kühlkörper 3 mehrere Öffnungen 25 aufweist in denen die Kühlplatten 5 der Leistungshalbleitermodule 3, wie oben beschrieben, angeordnet und gegen den Kühlkörper 2 flüssigkeitsdicht abgedichtet sind. Das Verfahren zur Herstellung einer Leistungshalbleitereinrichtung läuft, falls die erfindungsgemäße Leistungshalbleitereinrichtung 1 mehrere Leistungshalbleitermodule 3 aufweist, in analoger Form wie oben beschrieben ab.

Ferner sei angemerkt, dass der Kühlkörper 2 einstückig oder aus miteinander verbundenen Stücken ausgebildet sein kann.

Weiterhin sei an dieser Stelle angemerkt, das selbstverständlich Merkmale von verschiedenen Ausführungsbeispielen der Erfindung, sofern sich die Merkmale nicht gegenseitig ausschließen, beliebig miteinander kombiniert werden können.

## Patentansprüche

1. Leistungshalbleitereinrichtung mit einem Leistungshalbleitermodul (3) und einem von einer Flüssigkeit durchströmbaren Kühlkörper (2), wobei das Leistungshalbleitermodul (3) Leistungshalbleiterbauelemente (9), die auf elektrisch leitenden Leiterbahnen (13) angeordnet sind, aufweist, wobei das Leistungshalbleitermodul (3) eine elektrisch nicht leitende Isolationsschicht (6) und eine Kühlplatte (5) aufweist, wobei die Isolationsschicht (6) zwischen den Leiterbahnen (9) und der Kühlplatte (5) angeordnet ist, wobei der Kühlkörper (2) eine Öffnung (25) aufweist, die von einer die Öffnung (25) umlaufenden lateralen ersten Fläche (26) des Kühlkörpers (2) begrenzt wird, wobei die Kühlplatte (5) in der Öffnung (25) angeordnet ist, wobei eine die Kühlplatte (5) umlaufende laterale erste Fläche (24) der Kühlplatte (5) einen Winkel (α) zu einer den Leistungshalbleiterbauelementen (9) zugewandten Hauptfläche (30) der Kühlplatte (5) von kleiner als 90° aufweist und dieerste Fläche (26) des Kühlkörpers zu der den Leistungshalbleiterbauelementen (9) zugewandten Hauptfläche (30) der Kühlplatte (5) einen Winkel (β) von kleiner als 90° aufweist, wobei die erste Fläche (24) der Kühlplatte (5) und die erste Fläche (26) des Kühlkörpers (2), umlaufend entlang der ersten Fläche (24) der Kühlplatte (5) und umlaufend entlang der ersten Fläche (26) des Kühlkörpers (2), aneinander gepresst angeordnet sind.

2. Leistungshalbleitereinrichtung nach Anspruch 2, **dadurch gekennzeichnet, dass** die die Kühlplatte (5) umlaufende laterale erste Fläche (24) der Kühlplatte (5) einen Winkel (α) zu der den Leistungshalbleiterbauelementen (9) zugewandten Hauptfläche (30) der Kühlplatte (5) von 89,5° bis 85° aufweist.

3. Leistungshalbleitereinrichtung nach einem der vorhergehenden Ansprüche, **dadurch gekennzeichnet, dass** die erste Fläche (26) des Kühlkörpers (2) zu der den Leistungshalbleiterbauelementen (9) zugewandten Hauptfläche (30) der Kühlplatte (5) einen Winkel (β) aufweist, der gleich dem Winkel (α) der ersten Fläche (24) der Kühlplatte (5) zu der den Leistungshalbleiterbauelementen (9) zugewandten Hauptfläche (30) der Kühlplatte (5) ist.

4. Leistungshalbleitereinrichtung nach einem der vorhergehenden Ansprüche, **dadurch gekennzeichnet, dass** der Kühlkörper (2) eine Öffnung (25) aufweist, die von der die Öffnung (25) umlaufenden lateralen ersten Fläche (26) und von einer die Öffnung (25) umlaufenden lateralen zweiten Fläche (14) des Kühlkörpers (2) begrenzt wird, wobei die zweite Fläche (14) des Kühlkörpers (2), die Innenfläche einer um die Öffnung (25) umlaufenden ersten Nut (36) bildet, wobei ein Randbereich (29) der Kühlplatte (5) eine um die Kühlplatte (5) umlaufende Auswölbung (34) aufweist, die in der ersten Nut (36) angeordnet ist.

5. Verfahren zur Herstellung einer Leistungshalbleitereinrichtung mit folgenden Verfahrensschritten:
a) Bereitstellen eines Leistungshalbleitermoduls (3), das Leistungshalbleiterbauelemente (9), die auf elektrische leitenden Leiterbahnen (13) angeordnet sind, aufweist, wobei das Leistungshalbleitermodul (3) eine elektrisch nicht leitende Isolationsschicht (6) und eine Kühlplatte (5) aufweist, wobei die Isolationsschicht (6) zwischen den Leiterbahnen (9) und der Kühlplatte (5) angeordnet ist, wobei eine die Kühlplatte (5) umlaufende laterale erste Fläche (24) der Kühlplatte (5) einen Winkel (α) zu einer den Leistungshalbleiterbauelementen (9) zugewandten Hauptfläche (30) der Kühlplatte (5) von kleiner als 90° aufweist, und Bereitstellen eines von einer Flüssigkeit durchströmbaren Kühlkörpers (2), der eine Öffnung (25) aufweist, die von einer die Öffnung (25) umlaufenden lateralen ersten Fläche (26) des Kühlkörpers (2) begrenzt wird,
b) Anordnen der Kühlplatte (5) an der Öffnung (25) des Kühlkörpers (2),
c) Einpressen der Kühlplatte in die Öffnung des Kühlkörpers (2), wobei nach dem Einpressen die erste Fläche (24) der Kühlplatte (5) und die erste Fläche (26) des Kühlkörpers (2) umlaufend entlang der ersten Fläche (24) der Kühlplatte (5) und umlaufend entlang der ersten Fläche (269 des Kühlkörpers (2) aneinander gepresst angeordnet sind, wobei die erste Fläche (26) des Kühlkörpers (2) zu der den Leistungshalbleiterbauelementen (9) zugewandten Hauptfläche (30) der Kühlplatte (5) einen Winkel (β) von kleiner als 90° aufweist.

6. Verfahren nach Anspruch 5, wobei die Öffnung (25) von der die Öffnung (25) umlaufenden lateralen ersten Fläche (26) des Kühlkörpers (2) und von einer die Öffnung (25) umlaufenden lateralen zweiten Fläche (14) des Kühlkörpers (2) begrenzt wird, wobei die zweite Fläche (14) des Kühlkörpers (2), die Innenfläche einer um die Öffnung (25) umlaufenden ersten Nut (36) bildet, mit folgendem weiteren Verfahrensschritt:
d) Verformen eines lateralen Randbereichs (29) der Kühlplatte (5) derart, dass der Randbereich (29) eine um die Kühlplatte (5) umlaufende Auswölbung (34) aufweist, die nach dem Verformen des lateralen Randbereichs (29) der Kühlplatte (5) in der ersten Nut (14) angeordnet ist.

7. Verfahren nach Anspruch 6, **dadurch gekennzeichnet, dass** beim Einpressen der Kühlplatte (5) in die Öffnung (25) des Kühlkörpers (2) ein Einschneiden einer von der ersten Fläche (24) der Kühlplatte (5) beanstandeten umlaufenden zweiten Nut (28) in die den Leistungshalbleiterbauelementen (9) zugewandte Hauptfläche (30) der Kühlplatte (5) durchgeführt wird.

8. Verfahren nach Anspruch 6, **dadurch gekennzeichnet, dass** beim Verfahrensschritt a) die den Leistungshalbleiterbauelementen (9) zugewandte Hauptfläche (30) der Kühlplatte (5) eine von der ersten Fläche (24) der Kühlplatte (5) beanstandete umlaufende zweite Nut (28) aufweist.

9. Verfahren nach einem der Ansprüche 5 bis 8, **dadurch gekennzeichnet, dass** das Verfahren mittels eines einen Einpressstempels (51) und einen Verformstempel (52) aufweisenden Werkzeugs (50) durchführt wird, wobei das Einpressen der Kühlplatte (5) in die Öffnung (25) des Kühlkörpers (2) mittels des Einpressstempels (51) durchgeführt wird und das Verformen des lateralen Randbereichs (29) der Kühlplatte (5) mittels des Verformstempels (52) durchgeführt wird, wobei der Verformstempel (52) lateral um den Einpressstempel (51) herum und gegenüber dem Einpressstempel (51) beweglich angeordnet ist.
